# EUROPÄISCHE PATENTSCHRIFT

(11) **EP 3 052 339 B1**
(45) Veröffentlichungstag und Bekanntmachung des Hinweises auf die Patenterteilung: **02.01.2019**
(21) Anmeldenummer: 14755781.3
(22) Anmeldetag: 27.08.2014
(51) Int. Cl.: B60N 2/02, H03K 17/96

(54) **BEDIENVORRICHTUNG ZUM BEDIENEN EINES VERSTELLBAREN SITZES EINES KRAFTFAHRZEUGS**
OPERATING DEVICE FOR OPERATING AN ADJUSTABLE SEAT OF AN AUTOMOTIVE VEHICLE
DISPOSITIF DE COMMANDE POUR COMMANDER UN SIÈGE RÉGLABLE D'UN VÉHICULE AUTOMOBILE

(30) Priorität: 30.09.2013 DE 102013016340
(43) Veröffentlichungstag der Anmeldung: 10.08.2016
(73) Patentinhaber: Daimler AG, 70327 Stuttgart (DE)
(72) Erfinder: ENTENMANN, Volker, 71563 Affalterbach (DE); GERHARDT, Volker, 71101 Schönaich (DE); REISINGER, Jörg, 74369 Löchgau (DE); ZHANG-XU, Tingting, 71069 Sindelfingen (DE)
(74) Vertreter: JENSEN & SON
(86) Internationale Anmeldenummer: PCT/EP2014/002336
(87) Internationale Veröffentlichungsnummer: WO 2015/043709

(56) Entgegenhaltungen:
- EP-A2- 1 839 941
- WO-A1-01/35328
- DE-C1- 19 806 479

## Beschreibung

Die vorliegende Erfindung betrifft eine Sitzbedienvorrichtung eines Kraftfahrzeugs.

Moderne Kraftfahrzeuge sind zunehmend mit elektrisch verstellbaren Sitzen ausgestattet. Die verstellbaren Sitze umfassen beispielsweise Elektromotoren, mit denen das Sitzkissen, die Rückenlehne und die Kopfstütze verstellt werden können. Die verstellbaren Sitze können mittels einer entsprechenden Bedienvorrichtung, d.h. eines Sitzverstellschalters, eingestellt werden. Die Sitzbedienvorrichtungen weisen ein entsprechendes Bedienelement und eine Sensoreinrichtung auf, mit der eine Bedieneingabe an dem Bedienelement erfasst werden kann.

Heutzutage weisen derartige Sitzverstellschalter ein mechanisches Bedienelement auf. Dieses kann durch eine Tastenkappe gebildet sein, die auf einem Vierwegesteller gelagert und linear geführt ist. Das Auslösen einer Funktion erfordert eine Bewegung der Tastenkappe und das Überwinden einer Auslösekraft. Um ein sicheres Zurückstellen der ausgelenkten Tastenkappe unter allen Temperaturbedingungen zu gewährleisten, muss aufgrund der hohen Reibung in den Linearführungen das Kraftniveau für das Betätigen beziehungsweise Bedienen derart stark angehoben werden, dass ein Bedienkomfort leidet. Dies steht dem generellen Wunsch nach einem kraftreduzierten Bedienen der Bedienelemente in einem Kraftfahrzeug entgegen.

Aus der DE 10 2005 044 599 A1 ist eine Steuereinheit zum selektiven Einstellen eines automatisch verstellbaren Sitzes für ein Kraftfahrzeug bekannt. Die Steuereinheit weist eine Sitzverstellvorrichtung mit mehreren kontaktlosen und punktuell vorgesehenen Sensoren auf. Jeder Sensor ist an einer inneren Oberfläche eines Auswahlbereichs bei einer entsprechenden Vertiefung angebracht und erzeugt auf ein Betätigen selektiv ein Signal. Das Signal jedes Sensors ist selektiv einer vorbestimmten Sitzeinstellungsfunktion zugeordnet.

Aus der WO 01/35328 A1 ist ein Eingabegerät zur Steuerung einer Bewegung eines Objektes oder zur Steuerung eines Cursors auf einem Bildschirm bekannt. Eine auf eine Bedienfläche des Eingabegerätes angreifende Kraft wird über Kraftsensoren ermittelt, die ermittelte Kraft wird zur Steuerung der Bewegung des Objektes oder des Cursors auf einem Bildschirm verwendet.

Die DE 19806479 C1 offenbart eine Steuereinrichtung zur Steuerung von Stellmotoren für die Verstellung von Sitzteilen eines Sitzes mit Griffbereichen aus einem harten unverformbaren Kern und einer eine Betätigungsoberfläche bildenden, den Kern umfassenden flexiblen Ummantelung. Zwischen der flexiblen Ummantelung und dem unverformbaren Kern ist für jeden der Stellmotoren ein Signalgeber angeordnet.

Die EP 1 839 941 A2 offenbart eine Sitzsteuereinrichtung mit einem als Gewebe ausgeführten Berührungssensor und einem Steuerschaltkreis, der in Abhängigkeit von Signalen des Berührungssensors Steuersignale zum Steuern eines Fahrzeugsitzes erzeugt.st Aufgabe der vorliegenden Erfindung, eine Sitzbedienvorrichtung eines Kraftfahrzeugs zu schaffen, die ein einfaches, intuitives und zuverlässiges Bedienen des verstellbaren Sitzes zulässt.

Diese Aufgabe wird mit den in Anspruch 1 angegebenen Maßnahmen gelöst.

Weitere vorteilhafte Ausgestaltungen der vorliegenden Erfindung sind Gegenstand der abhängigen Ansprüche.

Gemäß einem Aspekt weist eine Sitzbedienvorrichtung eines Kraftfahrzeugs ein Trägerelement, ein Bedienelement, das eine an einer Außenfläche des Trägerelements angeordnete erste Oberfläche, eine zweite Oberfläche und zumindest eine an die erste Oberfläche und die zweite Oberfläche angrenzende dritte Oberfläche aufweist, eine Sensoreinrichtung zum Erfassen einer Größe einer bei der Bedieneingabe auf die zumindest eine dritte Oberfläche wirkenden Kraft und zum Erzeugen eines der Größe der erfassten Kraft entsprechenden Signals, eine Auswerteeinrichtung zum Erzeugen eines Steuersignals durch Verarbeiten des der Größe der erfassten Kraft entsprechenden Signals, und eine Verstelleinrichtung zum Verstellen des verstellbaren Sitzes auf der Grundlage des Steuersignals auf. Das Bedienelement ist mit zumindest einem Halteelement über eine entsprechende Lagerstelle an dem Trägerelement starr angeordnet und die Sensoreinrichtung in der Lagerstelle integriert.

Das Trägerelement der Sitzbedienvorrichtung kann an einer Türinnenverkleidung angeordnet sein. Ebenso ist es denkbar, dass das Trägerelement Teil einer Türinnenverkleidung ist. Das Trägerelement kann auch an dem Armaturenbrett, der Mittelkonsole oder seitlich an dem verstellbaren Sitz, insbesondere einem Sitzkissen, angeordnet sein. An dem Trägerelement ist ein Bedienelement starr angeordnet. Mit anderen Worten ist das Bedienelement nicht beweglich zu dem Trägerelement ausgebildet. Das Bedienelement kann als entsprechende Tastenkappe ausgebildet sein. Das Bedienelement kann der Form eines Sitzes eines Kraftfahrzeugs nachgebildet sein.

Mit der Sensoreinrichtung der Sitzbedienvorrichtung kann eine Bedieneingabe an der zumindest einen dritten Oberfläche des Bedienelements erfasst werden. Mittels der Sensoreinrichtung kann eine Kraft erfasst werden, die beispielsweise während der Bedieneingabe mit einem Finger auf die zumindest eine dritte Oberfläche des Bedienelements ausgeübt wird. Dabei kann mit der Sensoreinrichtung auch eine Amplitude der Kraft erfasst werden. In Abhängigkeit von der erfassten Bedieneingabe wird ein entsprechendes Steuersignal für die Verstelleinrichtung des Sitzes bereitgestellt. Somit kann durch einen leichten Druck auf die zumindest eine dritte Oberfläche des Bedienelements ein entsprechendes Sitzelement des Sitzes verstellt werden. Die Funktionsrückmeldung erfolgt dabei direkt durch den sich bewegenden Sitz. Durch das weglose Bedienelement kann der Einfluss von Reibungskräften auf die Bedienkräfte eliminiert werden. Dadurch kann für die Auslösekraft ein niedriges, angenehmes Niveau gewählt werden. Gleichzeitig bietet die Kraftsensitivität eine hohe Bediensicherheit.

Die Sensoreinrichtung kann so ausgebildet sein, dass sich unter Einwirkung von Druck auf die Sensoreinrichtung der elektrische Widerstand der Sensoreinrichtung ändert. Derartige Sensoreinrichtungen sind unter der Bezeichnung Force Sensitive Resistor bekannt.

Die Auswerteeinrichtung erzeugt dabei die Steuersignale derart, dass die Verstelleinrichtung bei einer auf die dritte Oberfläche wirkenden Kraft oberhalb einem oberen Schwellwert startet und unterhalb einem unteren, gegenüber dem oberen Schwellwert kleineren Schwellwert stoppt.

Gemäß einer Ausgestaltung steuert die Verstelleinrichtung eine Verstellgeschwindigkeit des verstellbaren Sitzes in Abhängigkeit der Größe der auf die zumindest eine dritte Oberfläche wirkenden Kraft. Die Verstellung des Sitzes kann dabei so gewählt werden, dass die Verstellgeschwindigkeit, mit der der Sitz verstellt wird, proportional zu der Größe der Kraft erfolgt, die auf das Bedienelement ausgeübt wird. Dies ermöglicht eine besonders komfortable Verstellung des Sitzes.

Das Bedienelement ist mit zumindest einem Halteelement an dem Trägerelement angeordnet und erfasst mit der Sensoreinrichtung eine auf das Halteelement wirkende Kraft.

Dadurch kann das Bedienelement mit dem zumindest einen Halteelement starr bzw. ortsfest an dem Trägerelement angeordnet sein. Das Bedienelement kann beispielsweise mit zwei Halteelementen an der Außenfläche des Trägerelements starr gelagert sein. Die Halteelemente sind mittels entsprechender Lagerstellen an dem Trägerelement befestigt. In den starren Lagerstellen sind Kraftsensoren angeordnet sein, mittels welcher eine auf die zumindest eine dritte Oberfläche des Bedienelements ausgeübte Bedieneingabe erfasst werden kann. Somit kann eine robuste und kostengünstige Variante für eine Bedienvorrichtung zum Bedienen eines verstellbaren Sitzes bereitgestellt werden.

Gemäß einer weiteren Ausgestaltung dehnt sich die zumindest eine dritte Oberfläche im Wesentlichen senkrecht zu der Außenfläche des Trägerelements aus.

Gemäß einer weiteren Ausgestaltung weist das Bedienelement ein erstes Bedienteil zum Bedienen eines Sitzkissens des verstellbaren Sitzes und ein zweites Bedienteil zum Bedienen einer Rückenlehne des verstellbaren Sitzes auf.

Gemäß einer weiteren Ausgestaltung weist das Bedienelement ein drittes Bedienteil zum Bedienen einer Kopfstütze des verstellbaren Sitzes auf.

Das Bedienelement kann die Form eines Sitzes eines Kraftfahrzeugs aufweisen. Jedes der Bedienteile kann eine Sensoreinrichtung beziehungsweise einen entsprechenden Sensor umfassen, mit dem eine Betätigungskraft zumindest einer Seitenfläche des jeweiligen Bedienteils erfasst werden kann. Diese ermöglicht eine einfache und intuitive Verstellung des Sitzes.

Die vorliegende Erfindung wird nachstehend anhand von Ausführungsformen unter Bezugnahme auf die beiliegende Zeichnung näher erläutert, in der durchgängig durch die mehreren Ansichten gleiche oder entsprechende Teile mit gleichen Bezugszeichen bezeichnet sind.

Es zeigt:
- Fig. 1a, b, c: eine Sitzbedienvorrichtung zum Bedienen eines verstellbaren Sitzes eines Kraftfahrzeugs gemäß dem Stand der Technik;
- Fig. 2a, b, c: die Sitzbedienvorrichtung gemäß den Fig. 1a, 1b und 1c in einem ersten Bedienzustand;
- Fig. 3a, b, c: die Sitzbedienvorrichtung gemäß den Fig. 1a, 1b und 1c in einem zweiten Bedienzustand;
- Fig. 4a, b, c: die Sitzbedienvorrichtung gemäß den Fig. 1a, 1b und 1c in einem dritten Bedienzustand;
- Fig. 5a, b, c: eine Sitzbedienvorrichtung zum Bedienen eines verstellbaren Sitzes eines Kraftfahrzeugs gemäß einer ersten Ausführungsform;
- Fig. 6a, b, c: die Sitzbedienvorrichtung gemäß den Fig. 5a, 5b und 5c in einem ersten Bedienzustand;
- Fig. 7a, b, c: die Sitzbedienvorrichtung gemäß den Fig. 5a, 5b und 5c gemäß einer zweiten Ausführungsform;
- Fig. 8a, b, c: die Sitzbedienvorrichtung gemäß den Fig. 5a, 5b und 5c gemäß einer dritten Ausführungsform;
- Fig. 9a, b, c: eine Sitzbedienvorrichtung gemäß einer vierten Ausführungsform; und
- Fig. 10: eine Perspektivdarstellung der Sitzbedienvorrichtung gemäß einer Ausgestaltung der ersten bis vierten Ausführungsformen.

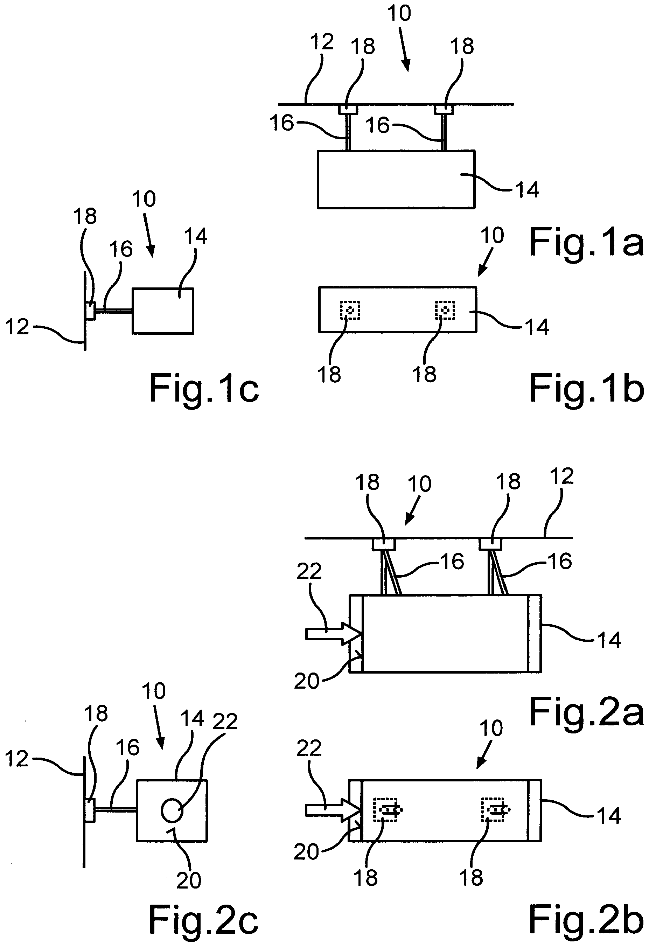

Die Fig. 1a, 1b und 1c zeigen eine Sitzbedienvorrichtung 10 zum Bedienen eines verstellbaren Sitzes eines Kraftfahrzeugs gemäß dem Stand der Technik. Der Sitz ist insbesondere mittels einer Verstelleinrichtung elektrisch verstellbar. Dabei zeigt Fig. 1a eine Draufsicht der Sitzbedienvorrichtung 10, Fig. 1b eine Vorderansicht der Sitzbedienvorrichtung 10 und Fig. 1c eine Seitenansicht der Sitzbedienvorrichtung 10. Die Sitzbedienvorrichtung 10 umfasst ein Trägerelement 12, das beispielsweise an einer Türinnenverkleidung eines Kraftfahrzeugs angeordnet sein kann. Das Trägerelement 12 kann auch Teil der Türinnenverkleidung des Kraftfahrzeugs sein. Des Weiteren umfasst Sitzbedienvorrichtung 10 ein Bedienelement 14, das mittels einer Betätigerstange 16 an dem Trägerelement 12 angeordnet ist. Des Weiteren umfasst die Sitzbedienvorrichtung 10 eine Sensoreinrichtung 18, mit der eine Bewegung beziehungsweise eine Auslenkung der Betätigerstange 16 erfasst werden kann. Im vorliegenden Beispiel ist die Sensoreinrichtung 18 als Vierwegeschalter ausgebildet.

Die Sitzbedienvorrichtung 10 dient vorliegend zum Verstellen eines Sitzkissens des Sitzes eines Kraftfahrzeugs. Um das Sitzkissen in horizontaler Richtung zu verstellen, bedarf es einer Bedieneingabe an einer ersten Seitenfläche 20 des Bedienelements 14. Dieser Bedienzustand ist in den Fig. 2a, 2b und 2c verdeutlicht, die eine entsprechende Auslenkung der Sitzbedienvorrichtung 10 gemäß den Fig. 1a, 1b und 1c zeigen. Die Krafteinwirkung, die beispielsweise durch den Finger einer Bedienperson beziehungsweise eines Fahrzeuginsassen auf die erste Seitenfläche 20 des Bedienelements 14 ausgeübt wird, ist vorliegend durch den Pfeil 22 verdeutlicht. Dabei muss das Bedienelement 14 durch die an der ersten Seitenfläche 20 angreifende Kraft so lange verschoben werden, bis eine Auslösekraft der Sensoreinrichtung 18 beziehungsweise der Vierwegeschalter überschritten wird und der elektrische Schaltpunkt erreicht wird. Der Zusammenhang zwischen Verstellweg und Auslösekraft wird dabei durch die Kraft-Weg-Charakteristik der beiden Vierwegeschalter festgelegt. Durch die seitliche Betätigung überträgt sich die Bewegung des Bedienelements 14 auf die beiden Vierwegeschalter, so dass sich deren Kräfte addieren.

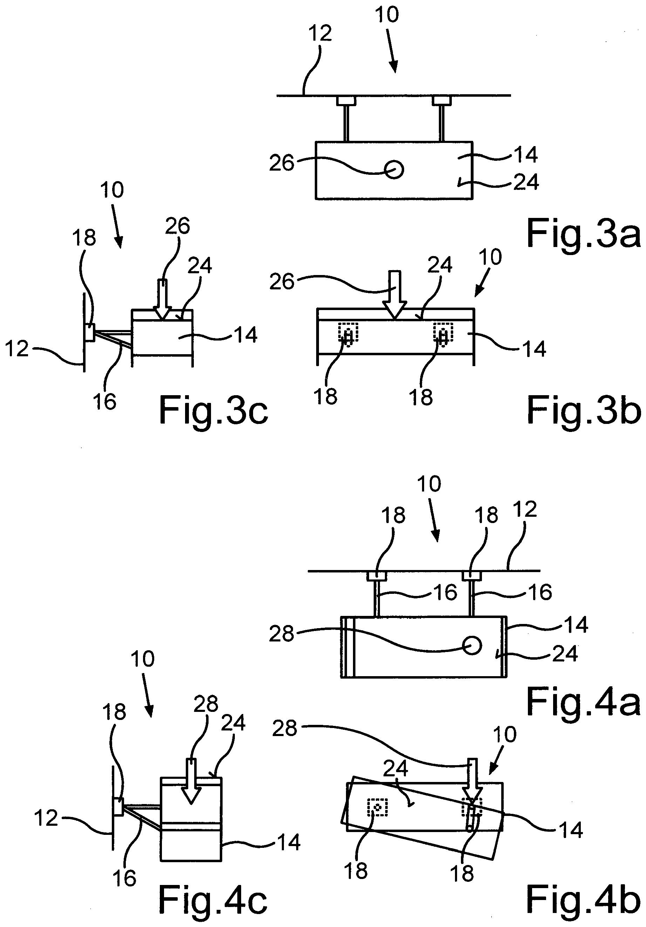

Analog kann das Sitzkissen in vertikaler Richtung durch eine an der oberen oder unteren Seitenfläche des Bedienelements 14 angreifende Betätigungskraft verstellt werden. Wirkt die Betätigungskraft mittig zwischen den beiden Vierwegestellern, dann verschiebt sich das Sitzkissen gleichförmig und ohne Rotation nach unten. Dies ist vorliegend in den Fig. 3a, 3b und 3c dargestellt, die eine entsprechende Auslenkung der Sitzbedienvorrichtung 10 gemäß den Fig. 1a, 1b und 1c darstellen. Hierbei wird eine Betätigungskraft auf eine zweite Seitenfläche 24 des Bedienelements 14 ausgeübt. Diese ist vorliegend durch den Pfeil 26 veranschaulicht. Um die Neigung des Sitzkissens zu verstellen, bedarf es einer vertikalen Betätigungskraft, die außermittig an der Seitenfläche 24 des Bedienelements 14 angreift. Dies ist in den Fig. 4a, 4b und 4c dargestellt, die eine entsprechende Auslenkung der Sitzbedienvorrichtung 10 gemäß den Fig. 1a, 1b und 1c darstellen. Vorliegend greift die Betätigungskraft, die durch den Pfeil 28 gekennzeichnet ist, nur an einem der Vierwegeschalter an. Dies bewirkt, dass nur dieser Vierwegeschalter ausgelenkt wird und der andere Vierwegeschalter in Ruhe bleibt. Damit muss auch nur eine Auslösekraft eines Vierwegeschalters überwunden werden.

Die oben beschriebene mechanische Ausführung der Sitzbedienvorrichtung 10 hat zwei Nachteile. Zum einen ergeben sich durch das mechanische Wirkprinzip unterschiedliche Auslösekräfte für das Verschieben des Sitzkissens und das Verstellen der Sitzkissenneigung. Zum anderen muss sichergestellt werden, dass sich das ausgelenkte Bedienelement 14 nach der Betätigung durch die Federkraft in den Vierwegestellern selbständig zurückstellt. Die Federkraft in den Vierwegeschaltern muss dabei so hoch gewählt werden, dass unter allen Temperatur- und Verschmutzungsbedingungen die Reibungskräfte in den Lagerführungen überwunden werden. Daraus resultiert aber ein so hohes Kraftniveau für die Betätigung des Bedienelements 14, dass der Bedienkomfort leidet und die Sitzbedienvorrichtung 10 in zunehmendem Widerspruch zu einer kraftreduzierten Bedienung im Kraftfahrzeug steht.

Nachstehend erfolgt die Beschreibung einer ersten Ausführungsform einer Sitzbedienvorrichtung.

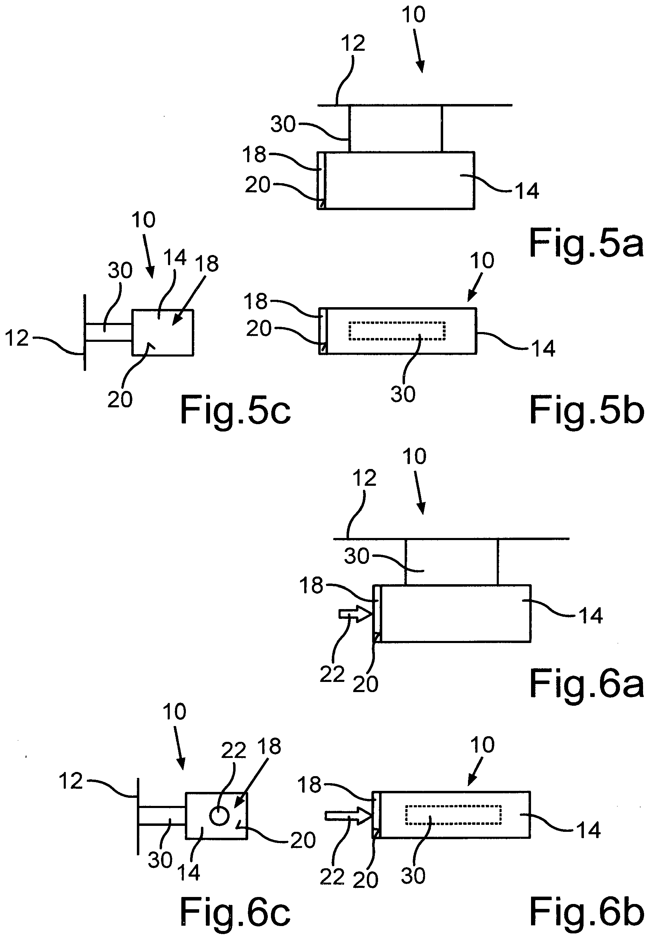

Die Fig. 5a, 5b und 5c zeigen eine Sitzbedienvorrichtung 10 zum Verstellen eines verstellbaren Sitzes eines Kraftfahrzeugs in der ersten Ausführungsform. Dabei zeigt Fig. 5a eine Draufsicht, Fig. 5b eine Vorderansicht und Fig. 5c eine Seitenansicht der Sitzbedienvorrichtung 10. Die Sitzbedienvorrichtung 10 umfasst ebenso ein Bedienelement 14, das an einem Trägerelement 12 angeordnet ist. Vorliegend ist das Bedienelement 14 mit einem flächigen Träger 30 an dem Trägerelement 12 angeordnet. Das Bedienelement 14 ist mittels des Trägers 30 starr bzw. ortsfest an dem Trägerelement 12 angeordnet. Zudem ist an der ersten Seitenfläche bzw. dritten, Oberfläche 20 des Bedienelements 14 eine Sensoreinrichtung 18 angeordnet. Dabei ist auch bevorzugt an den übrigen Seitenflächen bzw. dritten Oberflächen des Bedienelements eine Sensoreinrichtung 18 angeordnet. Die Sensoreinrichtung 8 ist dazu ausgebildet, eine Berührung der ersten Seitenfläche 20 in Folge einer Bedieneingabe zu erfassen. Dabei ist die Sensoreinrichtung 18 dazu ausgebildet, eine auf die Seitenfläche 20 wirkende Kraft, die in Folge der Bedieneingabe entsteht, zu erfassen.

Dabei kann die Sensoreinrichtung 18 auch dazu ausgebildet sein, eine Amplitude der auf die Seitenfläche 20 wirkenden Kraft zu erfassen.

Um das Sitzkissen horizontal zu verstellen, bedarf es einer Betätigungskraft an der ersten Seitenfläche 20 des Bedienelements 14. Dabei kann für das Ausgeben eines Steuersignals an eine Verstelleinrichtung eines Sitzes ein Schwellenwert für die auf die erste Seitenfläche 20 des Bedienelements 14 ausgeübte Kraft festgelegt werden. Um eine sichere Bedienung zu gewährleisten, ist es zudem vorteilhaft, einen oberen Schwellenwert für die auf die erste Seitenfläche 20 des Bedienelements 14 wirkende

Kraft für den Start des Verstellvorgangs des Sitzes und einen unteren Schwellenwert für die Kraft für das Ende des Verstellvorgangs zu definieren. Der untere Schwellenwert ist kleiner als der obere Schwellenwert. So wird vermieden, dass natürliche Kraftschwankungen beim Bedienen zu einem ständigen Starten und Anhalten der Sitzverstellung führen. Eine derartige Krafteinwirkung auf die erste Seitenfläche 20 des Bedienelements 14 beziehungsweise auf die Sensoreinrichtung 18 ist in den Fig. 6a, 6b und 6c dargestellt. Dabei ist die Krafteinwirkung durch den Pfeil 22 verdeutlicht.

Nachstehend erfolgt die Beschreibung einer zweiten Ausführungsform der Sitzbedienvorrichtung.

Ausgenommen der nachstehend beschriebenen Änderungen ist die zweite Ausführungsform identisch zu der ersten Ausführungsform, so dass die zuvor bezüglich der ersten Ausführungsform gemachten Äußerungen in dieser Hinsicht ebenso für die zweite Ausführungsform gelten.

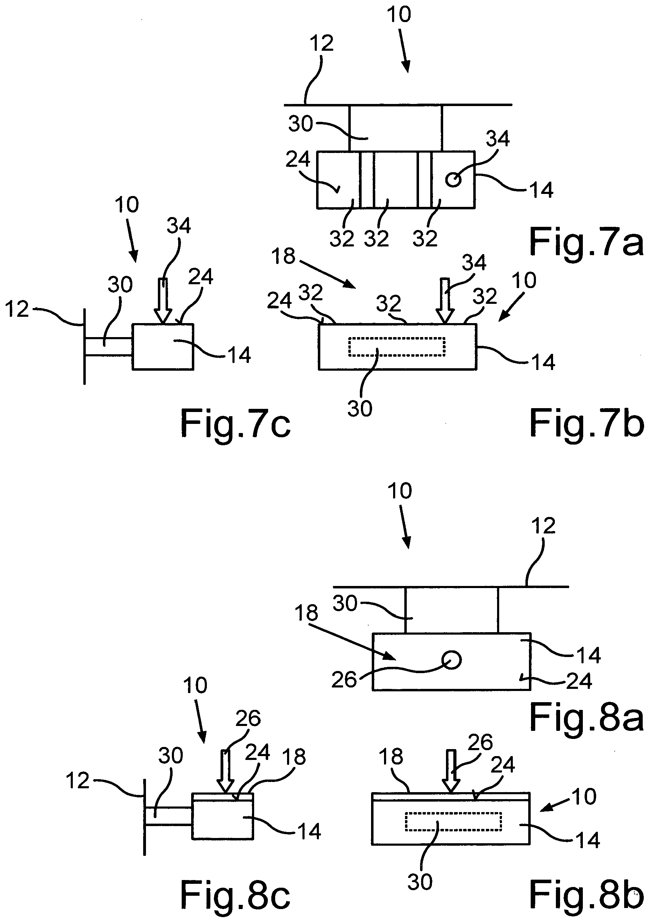

Um in vertikaler Richtung zwischen dem Verstellen der Sitzkissenhöhe und der Sitzkissenneigung unterscheiden zu können, muss der Angriffspunkt der Betätigungskraft an der oberen oder unteren Seitenfläche des Bedienelements 14 bestimmt werden. Zu diesem Zweck kann die Sensoreinrichtung 18 segmentiert werden. Die Fig. 7a, 7b und 7c zeigen eine Sitzbedienvorrichtung 10, bei der die Sensoreinrichtung 18 drei getrennte Sensorflächen 32 aufweist. Wenn eine Betätigungskraft auf die mittlere Sensorfläche 32 der Sensoreinrichtung 18 ausgeübt wird, dann wird die Sitzkissenhöhe verstellt. Greift die Betätigungskraft an einer der äußeren Sensorflächen 32 an, dann wird die Sitzkissenneigung verstellt. Dies ist vorliegend in den Fig. 7a, 7b und 7c dargestellt, bei der eine Betätigungskraft auf die rechte Sensorfläche 32 der Sensoreinrichtung 18 ausgeübt wird. Dies ist durch den Pfeil 34 angegeben.

Nachstehend erfolgt die Beschreibung einer dritten Ausführungsform der Sitzbedienvorrichtung.

Ausgenommen der nachstehend beschriebenen Änderungen ist die dritte Ausführungsform identisch zu der ersten und zweiten Ausführungsform, so dass die zuvor bezüglich der ersten und zweiten Ausführungsform gemachten Äußerungen in dieser Hinsicht ebenso für die dritte Ausführungsform gelten.

Alternativ zu einer Sensoreinrichtung 18, die segmentiert ausgebildet ist, kann auch eine Sensoreinrichtung 18 eingesetzt werden, bei der die Betätigungsposition des Fingers direkt bestimmt werden kann. Dies ist in den Fig. 8a, 8b und 8c veranschaulicht. Hierbei können der Höhen- und Neigungsverstellung beliebige Positionsbereiche der Sensoreinrichtung 18 beziehungsweise der Seitenfläche 24 zugewiesen werden.

Nachstehend erfolgt die Beschreibung einer vierten, der beanspruchten Erfindung entsprechenden Ausführungsform.

Ausgenommen der nachstehend beschriebenen Änderungen ist die vierte Ausführungsform identisch zu der ersten, zweiten und dritten Ausführungsform, so dass die zuvor bezüglich der ersten, zweiten und dritten Ausführungsform gemachten Äußerungen in dieser Hinsicht ebenso für die vierte Ausführungsform gelten.

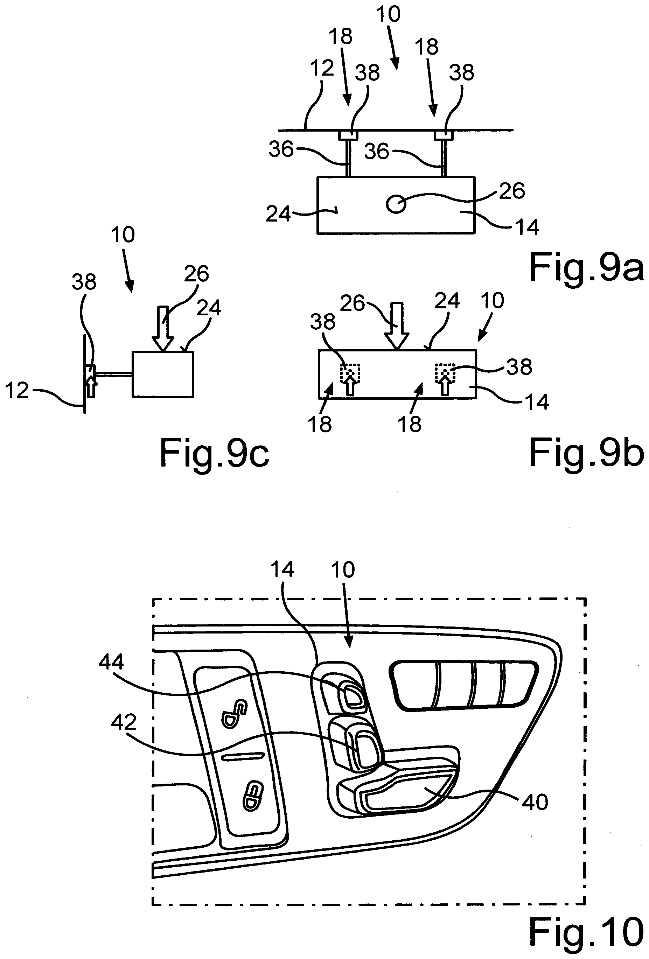

Die Fig. 9a, 9b und 9c zeigen eine Sitzbedienvorrichtung 10 in der vierten Ausführungsform. Dabei ist das Bedienelement 14 mittels zweier Halteelemente 36 über entsprechende Lagerstellen 38 an dem Trägerelement 12 starr angeordnet. In den Lagerstellen 38 sind entsprechende Kraftsensoren beziehungsweise Sensoreinrichtungen 18 integriert, die horizontale und vertikale Kräfte messen können. Aus den Reaktionskräften in den Lagerstellen 38 kann die Betätigungsposition des Fingers berechnet und so zwischen der Verstellung der Sitzkissenhöhe und der Sitzkissenneigung unterschieden werden.

Fig. 10 zeigt eine Perspektivdarstellung der Sitzbedienvorrichtung 10 gemäß einer Ausgestaltung der ersten bis vierten Ausführungsformen. Die Sitzbedienvorrichtung 10 umfasst ein erstes Bedienteil 40, das einem Sitzkissen des Sitzes zugeordnet ist, ein zweites das Bedienteil 42, das einer Rückenlehne des Sitzes zugeordnet ist und ein drittes Bedienteil 44, das einer Kopfstütze des Sitzes zugeordnet ist. Dabei kann jedes der Bedienteile 40, 42 und 44 gemäß den zuvor beschriebenen Ausführungsbeispielen betätigt werden.

Weitere Merkmale bzw. Vorteile der weglosen und kraftsensitiven Sitzbedienvorrichtung 10 gemäß den ersten bis vierten Ausführungsformen oder deren Ausgestaltung sind nachstehend angegeben.

Mit der gemessenen Betätigungskraft steht ein mehrstufiges oder sogar kontinuierliches Eingangssignal zur Verfügung, mit dem die Verstellgeschwindigkeit des Sitzes gesteuert werden kann. Je mehr Kraft der Benutzer auf das Bedienelement ausübt, umso schneller bewegt sich der Sitz. Damit kann insbesondere eine niedrige Grundverstellgeschwindigkeit gewählt werden, die ein sehr genaues Positionieren des Sitzes ermöglicht. Muss ein großer Verstellweg zurückgelegt werden, kann durch entsprechende Erhöhung der Betätigungskraft der Verstellvorgang beschleunigt werden. Solch eine Steuerung ist mit den heutigen mechanischen Sitzbedienvorrichtungen nicht möglich, da immer nur ein diskreter Schaltkontakt pro Betätigungsrichtung zur Verfügung steht.

Weiterhin kann bei der Bedienung beziehungsweise der Verstellung des Sitzes mittels der Sitzbedienvorrichtung dem Benutzer eine entsprechende Rückmeldung ausgegeben werden. Bei der Betätigung der Bedienvorrichtung ergibt sich eine direkte Rückmeldung, da sich der Sitz in Folge der Bedieneingabe an der Sitzbedienvorrichtung 10 in Bewegung setzt. Befindet sich der Sitz jedoch bereits im Anschlag eines Verstellwegs, und bedient der Benutzer dann in diese Richtung, erfolgt ohne weitere Maßnahme keine Funktionsrückmeldung. Eventuell führt das beim Benutzer zu Verwirrung und der Vermutung über eine vorliegende Funktionsstörung. Diesem Effekt kann entgegengewirkt werden, indem durch eine sehr kurze Bewegung des Sitzes in der zur Bedienung und zum Anschlag entgegengesetzter Richtung ein Ruck erzeugt wird, der den Benutzer den Anschlag meldet.

Eine besonders sichere Bedienung wird gewährleistet, indem ein oberer Schwellenwert für die auf die erste Seitenfläche bzw. dritte Oberfläche 20 des Bedienelements 14 wirkende Kraft für den Start des Verstellvorgangs des Sitzes und ein unterer Schwellenwert für die Kraft für das Ende bzw. Stoppen des Verstellvorgangs festgelegt wird. Der untere Schwellenwert ist kleiner als der obere Schwellenwert. So wird vermieden, dass natürliche Kraftschwankungen beim Bedienen zu einem ständigen Starten und Anhalten der Sitzverstellung führen.

Obgleich die vorliegende Erfindung vorhergehend anhand von Ausführungsformen unter Bezugnahme auf die beiliegende Zeichnung beschrieben worden ist, versteht es sich, dass verschiedene Änderungen und Ausgestaltungen durchgeführt werden können, ohne den Umfang der vorliegenden Erfindung zu verlassen, wie er in den beiliegenden Ansprüchen definiert ist.

Bezüglich weiterer Vorteile und Merkmale der vorliegenden Erfindung wird ausdrücklich auf die Offenbarung der Zeichnung verwiesen.

## Patentansprüche

1. Sitzbedienvorrichtung (10) zum Bedienen eines verstellbaren Sitzes eines Kraftfahrzeugs mit
- einem Trägerelement (12),
- einem Bedienelement (14), das eine zu einer Außenfläche des Trägerelements (12) gerichtete erste Oberfläche, eine zweite Oberfläche und zumindest eine an die erste Oberfläche und die zweite Oberfläche angrenzende dritte Oberfläche (20, 24) aufweist, einer Sensoreinrichtung (18) zum Erfassen einer Größe einer bei der Bedieneingabe auf die zumindest eine dritte Oberfläche (20, 24) wirkenden Kraft und zum Erzeugen eines der Größe der erfassten Kraft entsprechenden Signals wobei das Bedienelement (14) mit zumindest einem Halteelement (36) über eine entsprechende Lagerstelle (38) an dem Trägerelement (12) starr angeordnet ist und die Sensoreinrichtung (18) in der Lagerstelle integriert ist,
- einer Auswerteeinrichtung zum Erzeugen eines Steuersignals durch Verarbeiten des der Größe der erfassten Kraft entsprechenden Signals, und
- einer Verstelleinrichtung zum Verstellen des Sitzes auf der Grundlage des Steuersignals,
**dadurch gekennzeichnet, dass**
die Auswerteeinrichtung Steuersignale derart erzeugt, dass die Verstelleinrichtung bei einer auf die dritte Oberfläche wirkenden Kraft oberhalb einem oberen Schwellwert startet und unterhalb einem unteren, gegenüber dem oberen Schwellwert kleineren Schwellwert stoppt.

2. Sitzbedienvorrichtung (10) nach Anspruch 1,
**dadurch gekennzeichnet, dass**
die Verstelleinrichtung eine Verstellgeschwindigkeit des verstellbaren Sitzes in Abhängigkeit der Größe der auf die zumindest eine dritte Oberfläche (20, 24) wirkenden Kraft steuert.

3. Sitzbedienvorrichtung (10) nach Anspruch 1 oder 2,
**dadurch gekennzeichnet, dass**
sich die zumindest eine dritte Oberfläche (20, 24) im Wesentlichen senkrecht zu der Außenfläche des Trägerelements (12) ausdehnt.

4. Sitzbedienvorrichtung (10) nach einem der Ansprüche 1 bis 3,
**dadurch gekennzeichnet, dass**
das Bedienelement (14) ein erstes Bedienteil (40) zum Bedienen eines Sitzkissens des verstellbaren Sitzes und ein zweites Bedienteil (42) zum Bedienen einer Rückenlehne des verstellbaren Sitzes aufweist.

5. Sitzbedienvorrichtung (10) nach einem der Ansprüche 1 bis 4,
**dadurch gekennzeichnet, dass**
das Bedienelement (14) ein drittes Bedienteil (44) zum Bedienen einer Kopfstütze des verstellbaren Sitzes aufweist.

## Claims

1. Seat operating device (10) for operating an adjustable seat of a motor vehicle, with
- a support element (12),
- a control (14) having a first surface facing an outer surface of the support element (12), a second surface and at least one third surface (20, 24) adjoining the first surface and the second surface,
- a sensor device (18) for detecting a magnitude of a force acting on the at least one third surface (20, 24) at an operator input and for generating a signal corresponding to the magnitude of the detected force, wherein the control (14) is rigidly located on the support element (12) with at least one holding element (36) via a corresponding bearing point (38) and the sensor device (18) is integrated into the bearing point,
- an evaluation device for generating a control signal by processing the signal corresponding to the magnitude of the detected force, and
- an adjusting device for adjusting the seat on the basis of the control signal,
**characterised in that**
the evaluation device generates control signals in such a way that the adjusting device starts if a force above an upper threshold value acts on the third surface and stops below a lower threshold value which is lower than the upper threshold value.

2. Seat operating device (10) according to claim 1,
**characterised in that**
the adjusting device controls an adjustment speed of the adjustable seat as a function of the magnitude of the force acting on the at least one third surface (20, 24).

3. Seat operating device (10) according to claim 1 or 2,
**characterised in that**
the at least one third surface (20, 24) substantially extends perpendicular to the outer surface of the support element (12).

4. Seat operating device (10) according to any of claims 1 to 3,
**characterised in that**
the control (14) has a first control part (40) for operating a seat cushion of the adjustable seat and a second control part (42) for operating a back rest of the adjustable seat.

5. Seat operating device (10) according to any of claims 1 to 4,
**characterised in that**
the control (14) has a third control part (44) for operating a head rest of the adjustable seat.

## Revendications

1. Dispositif de commande de siège (10) destiné à commander un siège réglable d'un véhicule automobile comprenant
- un élément de support (12),
- un élément de commande (1'), qui présente une première surface orientée vers une surface extérieure de l'élément de support (12), une deuxième surface et au moins une troisième surface (20, 24) adjacente à la première surface et à la deuxième surface, un dispositif de détection (18) destiné à détecter une taille d'une force agissant lors de l'entrée opérationnelle sur ladite troisième surface (20, 24) et à produire un signal correspondant à la taille de la force détectée, l'élément de commande (14) comprenant un élément de retenue (36) étant disposé rigide au moyen d'un point d'appui sur l'élément de support (12) et le dispositif de détection (18) est intégré dans le point d'appui,
- un dispositif d'évaluation destiné à produire un signal de commande par traitement du signal correspondant à la taille de la force détectée, et
- un dispositif de déplacement destiné à déplacer le siège sur la base du signal de commande,
**caractérisé en ce que**
le dispositif d'évaluation produit des signaux de commande de sorte que le dispositif de déplacement démarre lorsqu'une force agissant sur la troisième valeur est au-dessus d'une valeur seuil supérieure et s'arrête en dessous une valeur seuil inférieure plus petite, par rapport à la valeur seuil supérieur.

2. Dispositif de commande de siège (10) selon la revendication 1, **caractérisé en ce que** le dispositif de déplacement commande une vitesse de déplacement du siège mobile en fonction de la taille de la force agissant sur ladite troisième surface (20, 24).

3. Dispositif de commande de siège (10) selon la revendication 1 ou la revendication 2, **caractérisé en ce que** ladite troisième surface (20, 24) s'étend sensiblement perpendiculairement à la surface extérieure de l'élément support (12).

4. Dispositif de commande de siège (10) selon l'une quelconque des revendications 1 à 3, **caractérisé en ce que** l'élément de commande (14) présente une première partie de commande (40) destinée à commander un coussin du siège réglable et une seconde partie de commande (42) destinée à commander un dossier du siège réglable.

5. Dispositif de commande de siège (10) selon l'une quelconque des revendications 1 à 4, **caractérisé en ce que** l'élément de commande (14) d'une troisième partie de commande (44) destinée à commander un appui-tête du siège réglable.
